# EUROPEAN PATENT APPLICATION

(11) **EP 1 722 245 A1**
(43) Date of publication of application: **15.11.2006**
(21) Application number: 06251299.1
(22) Date of filing: 10.03.2006
(51) Int. Cl.: G01R 31/26, G01R 31/317

(54) **Measurement of output voltage characeristics on dynamic logic signals**

(30) Priority: 25.03.2005 US 89793
(71) Applicant: TEKTRONIX, INC., Beaverton, OR 97077 (US)
(72) Inventor: Ainsworth, Kenneth M., Aloha, Oregon 97006 (US)
(74) Representative: Hutchinson, Glenn Stanley

(57) **Abstract**

An apparatus for measuring Output Voltage characteristics on a dynamic logic signal at an output of a device under test (DUT) includes a comparator for comparing the voltage at the output with a threshold voltage to generate a control signal. The control signal is used to switch an appropriate current load to the output in response to the dynamic logic signal. A measurement of the voltage at the output provides the Output Voltage characteristics without requiring control of an input stimulus or a static logic level at the output.

## Description

### BACKGROUND OF THE INVENTION

The present invention relates to measuring characteristics of logic circuits, and more particularly to measuring Output Voltage characteristics on dynamic logic signals.

Logic devices typically specify Output Voltage characteristics as a function of load current. For example an Output "High" specification (V_{OH}) commonly states a minimum output voltage level, such as 2.4 V, while the device is sourcing a specified current level, such as 8 mA. A similar specification is typically made for the Output "Low" state (V_{OL}), but in this case a maximum output voltage level, such as 0.5 V, is specified while the device is sinking a specified current level, such as 8 mA. Taken together these two specifications allow a designer to calculate what kind of load may be attached to a device output, while still insuring that proper logic "High" and "Low" voltage levels are maintained.

Normally V_{OH} and V_{OL} testing is done on individual semiconductor chips using parametric test systems, such as those manufactured by Teradyne, Inc., Agilent Technologies, LTX Corporation and Credence Systems Corporation. The chip output is set to the desired output logic level ("High" or "Low") through appropriate stimulus at its input. Then a programmable current source forces a current level at the output and the resulting voltage level is measured. Often the current source is set to a variety of values, sweeping out a curve of Output Voltage vs. Output Current. However guaranteed specifications commonly list only two values - the minimum V_{OH} at rated "high" current I_{OH} and the maximum V_{OL} at rated "low" current I_{OL}.

Once these semiconductor chips are embedded in a design application, several issues exist. First, it may be difficult to directly set and maintain the output logic state so that a forcing output current may be applied and the output voltage measured. There may not be a way to apply the stimulus that fixes the output in the desired state. Second, the output may be dynamic, moving between the "High" and "Low" states. Since the forcing output current is different between the V_{OH} case (current flow out of the device) and the V_{OL} case (current flow into the device), the dynamic case may result in the wrong load being applied for some of the time. This may result in the output being driven above and below its rated voltage limits.

What is desired is a way to ensure that the appropriate forced current load is applied to the device output without requiring control of the input stimulus or requiring a static output state.

### BRIEF SUMMARY OF THE INVENTION

Accordingly embodiments the present invention provides a way of measuring Output Voltage characteristics on dynamic logic signals.

The objects, advantages and other novel features of embodiments of the present invention are apparent from the following detailed description when read in conjunction with the appended claims and attached drawing.

### BRIEF DESCRIPTION OF THE DRAWING

Fig. 1 is a block diagram view of a circuit for measuring Output Voltage characteristics on dynamic logic signals according to an embodiment of the present invention.
Fig. 2 is a voltage/current graphic view for the circuit of Fig. 1 according to an embodiment of the present invention.
Fig. 3 is a circuit diagram view of the circuit of Fig. 1 according to an embodiment of the present invention.

### DETAILED DESCRIPTION OF THE INVENTION

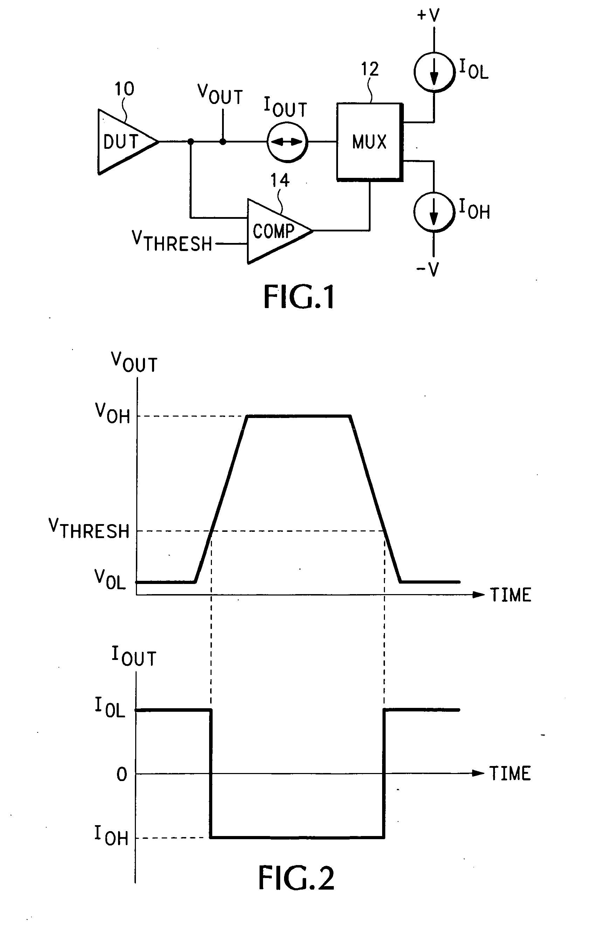

Referring now to Fig. 1 a logic device under test (DUT) **10** provides an output voltage V_{OUT} and a corresponding current I_{OUT}. The output current I_{OUT} is controlled by a multiplexer **12** having as inputs a plus voltage +V providing a current I_{OL} corresponding to a rated "low" current and a negative voltage -V providing a current I_{OH} corresponding to a rated "high" current. The output voltage V_{OUT} is also input to a voltage comparator **14** to which is also input a reference threshold voltage V_{THRESH}. The threshold voltage V_{THRESH} is chosen so that it lies in a transition region between a minimum output voltage level V_{OH} for a "High" logic state and a maximum voltage level V_{OL} for a "Low" logic state. The output from the voltage comparator **14** controls the state of the multiplexer **12.** As shown in the waveform diagrams of Fig. 2, when the DUT **10** Output Voltage is more positive than V_{THRESH}, I_{OH} is coupled to the DUT output as I_{OUT}. When the DUT **10** Output Voltage is more negative than V_{THRESH}, I_{OL} is coupled to the DUT output as I_{OUT}. In this way the appropriate load is coupled in either the "High" or "Low" logic state of the DUT **10** without the requirement of controlling the output state via an input stimulus or the requirement of having a static DUT output logic state. The V_{OH} and V_{OL} levels are then measured at Vₒᵤₜ with a voltage measurement device, such as a gated voltmeter, peak detector, oscilloscope or the like.

One potential problem with the above-described implementation is a momentary oscillation around the V_{THRESH} point. For example a DUT Vₒᵤₜ transitioning from "high" to "low" likely shows a transition rate change, or even slope reversal, when the load I_{OH} turns off and the load I_{OL} turns on. However the DUT achieves a steady state V_{OL} with I_{OL} applied, so the oscillation is transitory as long as V_{OL} and V_{THRESH} are not too close together. Hysteresis may be added around the comparator switch point to address this problem.

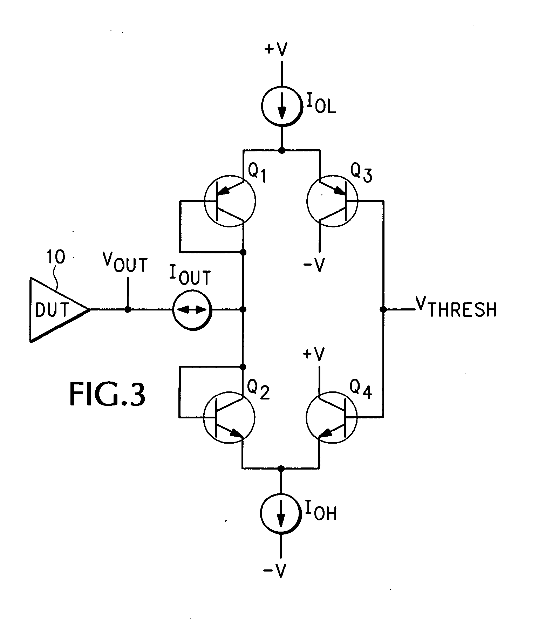

A practical implementation of the circuit described above is shown in Fig. 3. A couple of emitter-coupled transistor pairs **Q1, Q2** and **Q3, Q4** are connected together to form the multiplexer **12** and comparator **14** functions. The emitters of **Q1, Q3** are coupled to the I_{OL} source, while the emitters of **Q2, Q4** are coupled to the I_{OH} source. V_{THRESH} is applied to the bases of **Q3, Q4,** while the collectors are coupled to voltages -V and +V respectively. The bases and collectors of **Q1, Q2** are coupled to the DUT **10** output V_{OUT}. The operation of this circuit is as described above - when V_{OUT} < V_{THRESH}, I_{OUT} = I_{OL}; when Vₒᵤₜ> V_{THRESH}, I_{OUT} = I_{OH}. In other words when V_{OUT} is greater than V_{THRESH}, transistors **Q2 ,Q3** are turned on to couple the I_{OL} source to -V and the I_{OH} source to I_{OUT}, and when V_{OUT} less than V_{THRESH}, transistors **Q1, Q4** are turned on to couple the I_{OH} source to +V and the I_{OL} source to I_{OUT}.

Thus embodiments of the present invention provides an appropriate current load at the output of a logic device under test based upon a comparison of the device Output Voltage with a threshold voltage under dynamic signal conditions without the need to control input stimuli to the DUT. The Output Voltage is measured to determine the voltages for the "High" and "Low" logic states. It will be appreciated that the high and low logic states are embodiments of first and second state voltage levels.

## Claims

1. An apparatus for measuring Output Voltage characteristics on a dynamic logic signal at an output of a device under test comprising:
means coupled to the output for comparing an output voltage with a threshold voltage to generate a control signal, the threshold voltage being between a first state voltage level and a second state voltage level; and
means in response to the control signal for applying an appropriate load to the output so the first and second state voltage levels may be measured to determine the Output Voltage characteristics.
